(19) Europäisches Patentamt
European Patent Office
Office européen des brevets

(11) **EP 2 963 429 B1**

(12) **EUROPEAN PATENT SPECIFICATION**

(45) Date of publication and mention
of the grant of the patent:
**27.11.2019 Bulletin 2019/48**

(51) Int Cl.:
**G01R 27/18** $^{(2006.01)}$      *G01R 31/08* $^{(2006.01)}$
**G01R 31/02** $^{(2006.01)}$

(21) Application number: **15174382.0**

(22) Date of filing: **29.06.2015**

(54) **METHOD FOR DETECTING INSULATION IMPEDANCE OF POWER GRID CONNECTED WITH PHOTOVOLTAIC INVERTER AGAINST GROUND**

VERFAHREN ZUR ERKENNUNG DER ISOLATIONSIMPEDANZ EINES MIT EINEM GEERDETEN PHOTOVOLTAIKWECHSELRICHTER VERBUNDENEN STROMNETZES

PROCÉDÉ POUR DÉTECTER L'IMPÉDANCE D'ISOLATION D'UNE GRILLE DE PUISSANCE CONNECTÉE AVEC UN INVERSEUR PHOTOVOLTAÏQUE PAR RAPPORT À LA TERRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.06.2014 CN 201410308858**

(43) Date of publication of application:
**06.01.2016 Bulletin 2016/01**

(73) Proprietor: **Sungrow Power Supply Co., Ltd.**
**Hefei 230088 (CN)**

(72) Inventors:
• **LI, Xiaoxun**
**230088 Hefei (CN)**
• **LI, Haoyuan**
**230088 Hefei (CN)**
• **MEI, Xiaodong**
**230088 Hefei (CN)**
• **HAN, Zhiqiang**
**230088 Hefei (CN)**
• **WU, Touming**
**230088 Hefei (CN)**
• **HE, Chao**
**230088 Hefei (CN)**
• **SONG, Yang**
**230088 Hefei (CN)**

(74) Representative: **Brevalex**
**95, rue d'Amsterdam**
**75378 Paris Cedex 8 (FR)**

(56) References cited:
**EP-A1- 2 461 026      EP-A1- 2 677 330**
**EP-A2- 1 953 890      CN-A- 102 751 894**
**CN-U- 202 110 220      DE-A1-102011 007 222**
**GB-A- 2 381 322      US-A1- 2012 319 660**

**Description**

**FIELD**

The present disclosure relates to the field of photovoltaic power supply technology, and particularly to a device and method for detecting insulation impedance of a power grid connected with a photovoltaic inverter against ground.

**BACKGROUND**

In a grid-connected photovoltaic power generation system, direct current generated by a solar battery is converted to alternating current with the same frequency and phase as a voltage of the power grid. Hence the system can not only supply power to a load, but also transport electrical energy to the power grid. Specifically, a photovoltaic inverter is an important component in the grid-connected photovoltaic power generation system, and it connects a photovoltaic component array to the power grid.

In order to make the grid-connected photovoltaic power generation system secure and stable, insulation detection against ground is performed on the power grid connected with the photovoltaic inverter, to detect a resistance of the power grid relative to the ground. How to realize the insulation detection of the power grid against ground is an urgent issue in the photovoltaic power generation field.

Reference CN102751894 A discloses an inverter used for detecting a solar cell panel and an electric network side insulation resistor and a detection method. The inverter provided by the invention comprises a boosting unit and an inversion unit, wherein the boosting unit is connected in series with the inversion unit, and a two-stage relay is arranged between the tail end of the inversion unit and an electric network. According to the inverter and the method, a detection circuit is simplified.

Reference CN202110220 U discloses photovoltaic grid-connected inverter technology, in particular to a ground insulation resistance online detecting system for a photovoltaic grid-connected inverter, which comprises an upper bridge arm, a lower bridge arm, a resistance switch circuit, a power frequency interference suppression circuit, a voltage follower circuit, an isolation amplifier circuit, a microprocessor and a PV (photovoltaic) voltage detecting circuit for detecting the output voltage of a photovoltaic cell, wherein the microprocessor is provided with a detecting result output port. The ground insulation resistance online detecting system accurately computes the ground insulation resistance of a positive electrode and a negative electrode of the photovoltaic cell of the photovoltaic grid-connected inverter on line in real time, and outputs detecting results to the related circuits and equipment through the detecting result output port of the microprocessor, thereby ensuring the photovoltaic grid-connected inverter to run safely and reliably.

Reference US2012319660 A1 discloses a ground continuity circuit. In one embodiment, a first voltage of a signal associated with an electrical line input to a circuit is measured with respect to a first resistance value of the circuit. A ground continuity test signal is asserted into the circuit that causes the resistance value of the circuit to change to a second resistance value. A second voltage of the signal is measured with respect to the second resistance value. A ground impedance value of the circuit is determined as a function of the first and second measured voltages and the first and second resistance values.

Reference GB2381322 A discloses a loop impedance meter for testing an AC supply includes an electronic control circuit for connecting a load resistance R1 between the live and earth terminals of the supply. The value of R1, and the time for which it is connected, are selected so that the RCD protection in the supply is not tripped. Typically, the load resistance in ohms is between one sixth and one times the mains voltage in volts e.g. 100 L for a 230V supply, and it is connected for less than 100 s. Also disclosed is a loop impedance meter that desensitizes the RCD, before a measurement is made, by means of a series of short current pulses, the pulses consecutively increasing in width. In addition, a loop impedance meter is disclosed that applies several measurement pulses, and extrapolates the resulting measurements to give the impedance value at the AC mains frequency.

Reference EP1953890 A2 discloses the device which has electrical terminals connected to a phase conductor of an electric distribution network and ground, respectively. The device is designed as a two-pole or multi-pole switching network, where impedance and/or admittance of the two-pole or multi-pole switching network is modified continuously or in steps relative to both the terminals by a controller. A primary winding of a transformer or voltage converter is connected with the terminals. An independent claim is also included for a method for injecting an auxiliary signal into a null system of an electric distribution network.

Reference EP2461026 A1 discloses an arrangement for testing an electric power generation system, in particular a wind turbine system, which is supposed to be connected to an utility grid having a predetermined first impedance, the arrangement comprising: a input terminal for connecting the arrangement to an output terminal of the power generation system; a grid terminal for connecting the arrangement to the utility grid; and an electrical adjustment system connected between the input terminal and the grid terminal, wherein the electrical adjustment system is adapted to adjust an impedance at the input terminal to the predetermined first impedance, when an auxiliary grid having a second impedance different from the first impedance is connected at the grid terminal. Further a corresponding method is described.

## SUMMARY

In order to solve the technical problem described above, a method for detecting insulation impedance of a power grid connected with a photovoltaic inverter against ground is provided in the present disclosure, which can detect the insulation of the power grid connected with a photovoltaic inverter against ground, and acquire a resistance of the power grid relative to the ground.

The claimed invention is directed to such a detection method for detecting insulation of a power grid as defined in the alternative independent method claims 1 and 4. Advantageous embodiments are defined by the dependent method claims. The claimed methods use respective detection devices to detect the insulation of the power grid against ground.

In order to realize the object described above, the present disclosure provides the following technical solution.

A detection device for detecting insulation impedance of a power grid connected with a photovoltaic inverter against ground is used in the detection method, where the power grid includes a first live line, a second live line, a third live line and a zero line, and the detection device includes:

> a first resistor, where a first end of the first resistor is connected to a ground wire of the photovoltaic inverter, and a second end of the first resistor is connected to the first live line;
> a second resistor, where a first end of the second resistor is connected to the ground wire, and a second end of the second resistor is connected to the zero line; and
> a first series branch including a third resistor and a first switch device connected in series, where a first end of the first series branch is connected to the ground wire, and a second end of the first series branch is connected to the zero line or the first live line.

Preferably, the detection device further includes:

> a fourth resistor; and
> a second series branch including a fifth resistor and a second switch device connected in series, where the second series branch is connected in parallel with the fourth resistor to from a first parallel branch; and where a first end of the first parallel branch is connected to the ground wire, and a second end of the first parallel branch is connected to the second live line.

Preferably, the detection device further includes:

> a sixth resistor; and
> a third series branch including a seventh resistor and a third switch device connected in series, where the third series branch is connected in parallel with the sixth resistor to from a second parallel branch; and where a first end of the second parallel branch is connected to the ground wire, and a second end of the second parallel branch is connected to the third live line.

Preferably, the detection device further includes:
a second series branch including a fifth resistor and a second switch device connected in series, where a first end of the second series branch is connected to the ground wire; one of a second end of the second series branch and the second end of the first series branch is connected to the zero line, and the other of the second end of the second series branch and the second end of the first series branch is connected to the first live line.

Preferably, the detection device further includes:

> a sixth resistor; and

> a third series branch including a seventh resistor and a third switch device connected in series, where the third series branch is connected in parallel with the sixth resistor to form a second parallel branch; and where a first end of the second parallel branch is connected to the ground wire, and a second end of the second parallel branch is connected to the third live line.

A detection method for detecting insulation of a power grid connected with a photovoltaic inverter against ground is further provided in the present disclosure, to use the detection device described above to detect the insulation of the power grid against ground, and the detection method includes:

acquiring voltage values of the ground wire and a predetermined one of the live lines in different switch states of the switch device in the detection device by changing the switch state of the switch device; and

calculating a value of a resistance of the power grid relative to ground based on the voltage values.

Preferably, in the detection method described above, acquiring voltage values includes:
acquiring voltages of the ground wire and the first live line when the first switch device is turned off, and acquiring voltages of the ground wire and the first live line when the first switch device is turned on.

Preferably, in the detection method described above, the resistance relative to ground is a resistance of the zero line and the three live lines connected in parallel in the power grid relative to ground;
calculating a value of a resistance of the power grid relative to ground includes:
calculating the value of the resistances of the zero line and the three live lines connected in parallel in the power grid relative to ground based on the voltages by using a node current method.

Preferably, in the detection method described above, the detection device further includes: a fourth resistor, and a second series branch including a fifth resistor and a second switch device connected in series, and where the second series branch is connected in parallel with the fourth resistor to from a first parallel branch; where a first end of the first parallel branch is connected to the ground wire, and a second end of the first parallel branch is connected to the second live line;
acquiring voltage values includes: acquiring voltages of each live line and the ground wire in the power grid in each switch combination state by changing the switch combination state of the first switch device and the second switch device.

Preferably, in the detection method described above, the detection device further includes: a second series branch including a fifth resistor and a second switch device connected in series, where a first end of the second series branch is connected to the ground wire, and one of a second end of the second series branch and the second end of the first series branch is connected to the zero line, and the other of the second end of the second series branch and the second end of the first series branch is connected to the first live line; a sixth resistor; a third series branch including a seventh resistor and a third switch device connected in series, where the third series branch is connected in parallel with the sixth resistor to from a second parallel branch; where a first end of the second parallel branch is connected to the ground wire, and a second end of the second parallel branch is connected to the third live line, and where acquiring voltage values includes: acquiring voltages of each live line and the ground wire in the power grid in each of at least four switch combination states by changing the switch combination state of the first switch device, the second switch device and the third switch device.

Preferably, in the detection method described above, the resistance relative to ground includes a resistance of the first live line relative to ground, a resistance of the second live line relative to ground, a resistance of the third live line relative to ground and a resistance of the zero line relative to ground;
calculating a value of a resistance of the power grid relative to ground includes:
calculating the values of the resistance of the first live line relative to ground, the resistance of the second live line relative to ground, the resistance of the third live line relative to ground and the resistance of the zero line relative to ground based on the voltages by using a node current method.

It can be seen from the technical solution described above that, the detection device for detecting insulation impedance of the power grid connected with the photovoltaic inverter against ground provided in the present disclosure includes: the first resistor, where the first end of the first resistor is connected to the ground wire of the photovoltaic inverter, and the second end of the first resistor is connected to the first live line; the second resistor, where the first end of the second resistor is connected to the ground wire, and the second end of the second resistor is connected to the zero line; and the first series branch including the third resistor and the first switch device connected in series, where the first end of the first series branch is connected to the ground wire, and the second end of the first series branch is connected to the zero line or the first live line. In the detection method provided in the present disclosure, the voltages of the ground wire and a predetermined one of the live lines in the different switch states can be acquired by the detection device, the resistance of the power grid relative to ground can be calculated based on the voltages, hence the detection of the insulation of the power grid against ground is realized.

## BRIEF DESCRIPTION OF THE DRAWINGS

In order to more clearly illustrate the technical solution in the embodiments of the present disclosure or in the conventional technology, in the following, the drawings required in the description of the embodiments or the conventional technology will be introduced simply, obviously, the drawings in the following description are just some embodiments of the present disclosure, for those skilled in the art, other drawings may also obtained based on these drawings without any creative work

Figure 1 is a schematic structural diagram of a detection device for detecting insulation impedance of a power grid connected with a photovoltaic inverter against ground according to a first example of the present disclosure;

Figure 2 is a schematic structural diagram of another detection device for detecting insulation impedance of a power grid connected with a photovoltaic inverter against ground according to a first example of the present disclosure;

Figure 3 is an equivalent circuit diagram of the detection device shown in Figure 1;

Figure 4 is a schematic structural diagram of a detection device for detecting insulation impedance of a power grid connected with a photovoltaic inverter against ground used in a method according to a first embodiment of the invention.

Figure 5 is a schematic structural diagram of a detection device for detecting insulation impedance of a power grid connected with a photovoltaic inverter against ground used in a method according to a second embodiment of the invention.

Figure 6 is a schematic structural diagram of a detection device for detecting insulation impedance of a power grid connected with a photovoltaic inverter against ground used in a method according to a third embodiment of the invention; and

Figure 7 is a schematic structural diagram of a detection device for detecting insulation impedance of a power grid connected with a photovoltaic inverter against ground used in a method according to a fourth embodiment of the invention.

## DETAILED DESCRIPTION OF THE EMBODIMENTS

The technical solution in the embodiments of the present disclosure will be described clearly and completely below in conjunction with the drawings in the embodiments of the present disclosure. Obviously, the described embodiments are just a part of embodiments of the present disclosure, and are not all embodiments. The invention is defined by the claims.

First example

A detection device for detecting insulation impedance of a power gird connected with a photovoltaic inverter against ground is provided in the example.

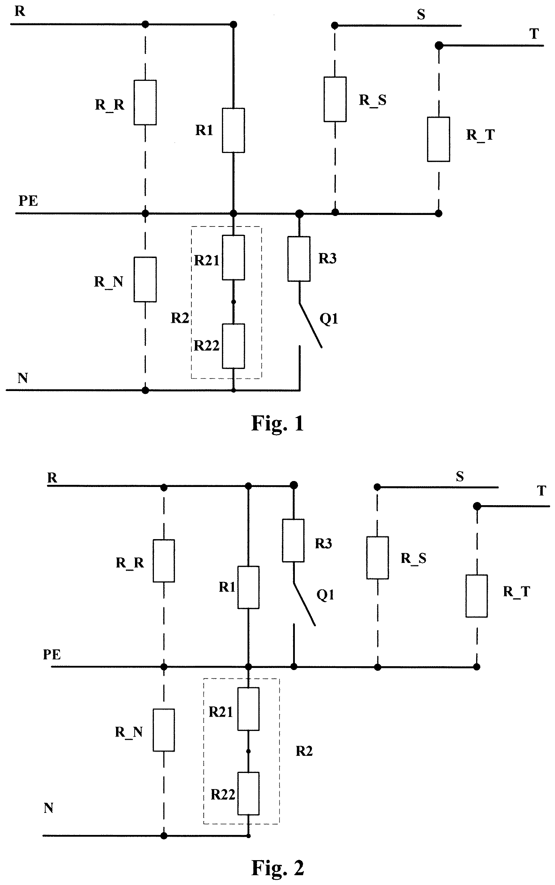

Reference is made to Figure 1, which is a schematic structural diagram of a detection device for detecting insulation impedance of a power gird connected with a photovoltaic inverter against ground according to a first example of the present disclosure, the power grid includes a first live line R, a second live line S, a third live line T and a zero line N, the detection device includes a first resistor R1, a second resistor R2 and a first series branch. R_R indicates a resistor of the first live line relative to ground, R_S indicates a resistor of the second live line relative to ground, R_T indicates a resistor of the third live line relative to ground, R_N indicates a resistor of the zero line relative to ground, and PE is a ground wire of the photovoltaic inverter.

A first end of the first resistor R1 is connected to the ground wire PE, and a second end of the first resistor R1 is connected to the first live line R. The three live lines in the power grid are equivalent to each other, that is, the second end of the first resistor R1 can be connected to any one of the live lines in the power grid.

A first end of the second resistor R2 is connected to the ground wire PE, and a second end of the second resistor R2 is connected to the zero line N. The zero line N of the power grid is a reference zero potential in the circuit. The second resistor R2 may be composed of a single resistor or multiple resistors connected in serious, for example a voltage division resistor R21 and a voltage division resistor R22 connected in serious as shown in Figure 1.

The first series branch includes a third resistor R3 and a first switch device Q1 connected in series. A first end of the first series branch is connected to the ground wire PE, and a second end of the first series branch is connected to the zero line.

In the example shown in Figure 1, the first series branch is connected in parallel with the resistor R_N of the zero line N relative to ground, in other embodiment, the second end of the first series branch may alternatively be connected to the first live line R, that is, the first series branch is connected in parallel with the resistor R_R of the first live line R relative to ground, as shown in Figure 2, which is a schematic structural diagram of another detection device for detecting insulation impedance of a power gird connected with a photovoltaic inverter against ground according to a first example of the present disclosure.

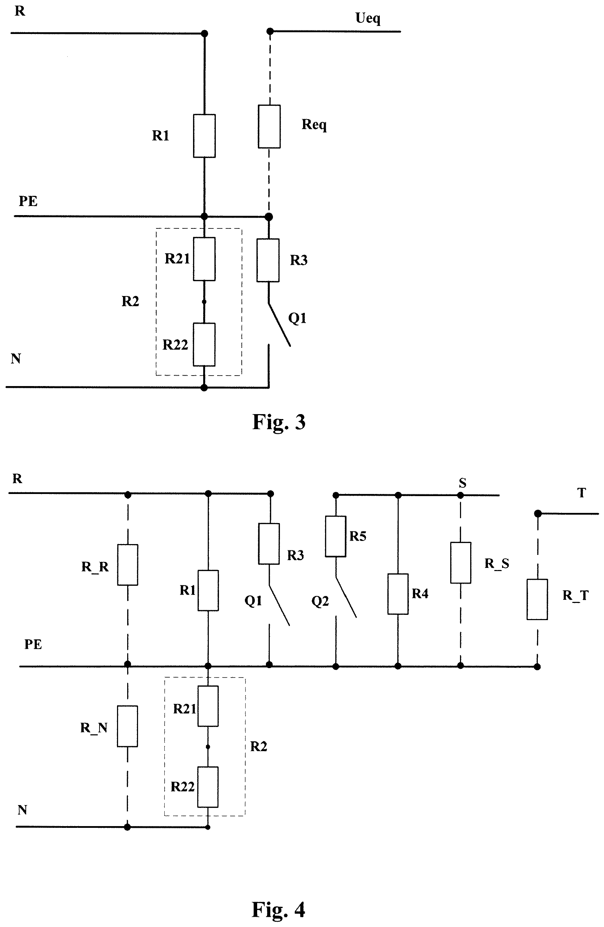

Reference is made to Figure 3, which is an equivalent circuit diagram of the detection device shown in Figure 1. Since the first live line R, the second live line S, the third live line T and the zero line N in the power grid are connected in parallel with each other, the resistors of these lines relative to ground may be equivalent to a parallel-connected-to-ground resistor Req, one end of the parallel-connected-to-ground resistor Req is connected to the ground wire PE, and an equivalent voltage of the other end is Ueq. Two sets of voltages of the first live line R and the ground wire PE can be obtained by changing a switch state of the first switch device, and thus the resistance value of the parallel-connected-

to-ground resistor Req can be obtained. It is determined whether the insulation of the power grid against ground is normal by comparing the resistance value of the parallel-connected to-ground resistor Req with a standard value.

In a process of acquiring a voltage of the ground wire PE, the voltage of the ground wire PE is calculated based on a detected voltage at a node between the voltage division resistor R21 and the voltage division resistor R22.

For the example shown in Figure 2, the resistance value of the parallel-connected-to-ground resistor Req of the power grid can be obtained in the same way.

First embodiment

A detection device for detecting insulation impedance of a power gird connected with a photovoltaic inverter against ground is used in the embodiment, with reference Figure 4, which is a schematic structural diagram of a detection device for detecting insulation impedance of a power gird connected with a photovoltaic inverter against ground used in a first embodiment of the present disclosure. Compared with the first example, the detection device in the first embodiment further includes a fourth resistor R4, a fifth resistor R5 and a second switch device Q2, where the fifth resistor R5 and the second switch device Q2 are connected in series to from a second series branch which is connected in parallel with the fourth resistor R4.

A first end of a first parallel branch including the second series branch and the fourth resistor R4 is connected to the ground wire PE, and a second end of the first parallel branch is connected to the second live line S, that is, the first parallel branch is connected in parallel with the resistor R_S of the second live line S relative to ground. Alternatively the second end of the first parallel branch may be connected to the third live line T, that is, the first parallel branch is connected in parallel with the resistor of the third live line T relative to ground.

Figure 4 only shows the first series branch is connected in parallel with the resistor R_R of the first live line R relative to ground, alternatively the first series branch may also be connected with parallel to the resistor R_N of the zero line N relative to ground.

According to the embodiment including the first switch device Q1 and the second switch device Q2, there are fourth switch combination states. The resistance values of the resistor of each of the live lines and the zero line relative to ground may be calculated by detecting the voltage of each of the first live line R, the second live line S, the third live line T and the ground wire PE in each of the four switch combination states, so as to realize the insulation detection of the power grid against ground. It is determined whether the insulation of the power grid against ground is normal by comparing the resistance value of each of the first live line R, the second live line S, the third live line T and the zero line N relative to ground with a standard value.

Second embodiment

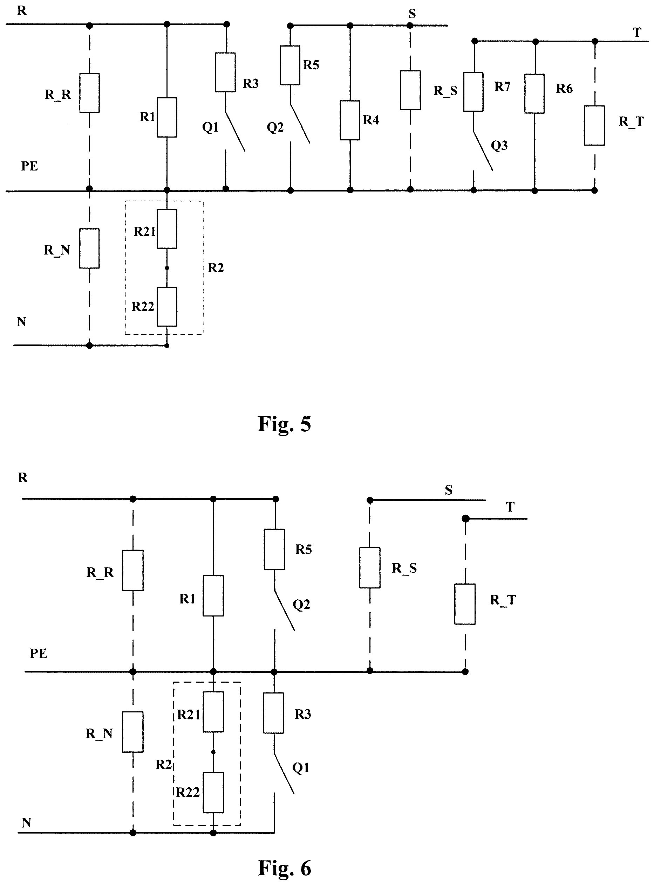

A detection device for detecting insulation impedance of a power gird connected with a photovoltaic inverter against ground is used in the embodiment. Reference is made to Figure 5, which is a schematic structural diagram of a detection device for detecting insulation impedance of a power gird connected with a photovoltaic inverter against ground according to a second embodiment of the present disclosure. Compared with the first embodiment, the detection device described in the second embodiment further includes a sixth resistor R6, a seventh resistor R7 and a third switch device Q3, where the seventh resistor R7 and the third switch device Q3 are connected in series to form a third series branch which is connected in parallel with the sixth resistor R6.

A first end of a second parallel branch including the third series branch and the sixth resistor R6 is connected to the ground wire, and a second end of the second parallel branch is connected to the third live line T, that is, the third series branch is connected in parallel with the resistor R_T of the third live line T relative to ground.

Figure 5 only shows the first series branch is connected in parallel with the resistor R_R of the first live line R relative to ground, alternatively the first series branch may also be connected in parallel with the resistor R_N of the zero line relative to ground.

According to the embodiment including the first switch device Q1, the second switch device Q2 and the third switch device Q3, there are eight switch combination states. The resistance values of the resistor of each of the live lines and the zero line N relative to ground may be calculated by detecting the voltage of each of the first live line R, the second live line S, the third live line T and the ground wire PE in any four combination states of the eight switch combination states, so as to realize the insulation detection of the power grid against ground. It is determined whether the insulation of the power grid against ground is normal by comparing the resistance value of each of the first live line R, the second live line S, the third live line T and the zero line N relative to ground with a standard value.

Third embodiment

A detection device for detecting insulation impedance of a power gird connected with a photovoltaic inverter against ground is used in the embodiment, with reference to Figure 6, which is a schematic structural diagram of a detection device for detecting insulation impedance of a power gird connected with a photovoltaic inverter against ground according to a third embodiment of the present disclosure. Compared with the first example, the detection device in the third embodiment further includes a fifth resistor R5 and a second switch device Q2 connected in series to form a second series branch. A first end of the second series branch is connected to the ground wire PE; one of a second end of the second series branch and the second end of the first series branch is connected to the zero line N, and the other one of the second end of the second series branch and the second end of the first series branch is connected to the first live line R. As shown in Figure 6, the second end of the second series branch is connected to the first live line R, and the second end of the first series branch is connected to the zero line N.

The detection device in the embodiment includes two switch devices, and the two switch devices have four switch states. Similar to the first embodiment, the resistance values of the resistor of each of the live lines and the zero line relative to ground can be calculated by detecting the voltage of each of the live lines and the ground wire PE in the four switch combination states, so as to realize the insulation detection of the power grid against ground. It is determined whether the insulation of the power grid against ground is normal by comparing the resistance value of each of the first live line R, the second live line S, the third live line T and the zero line N relative to ground with a standard value.

Fourth embodiment

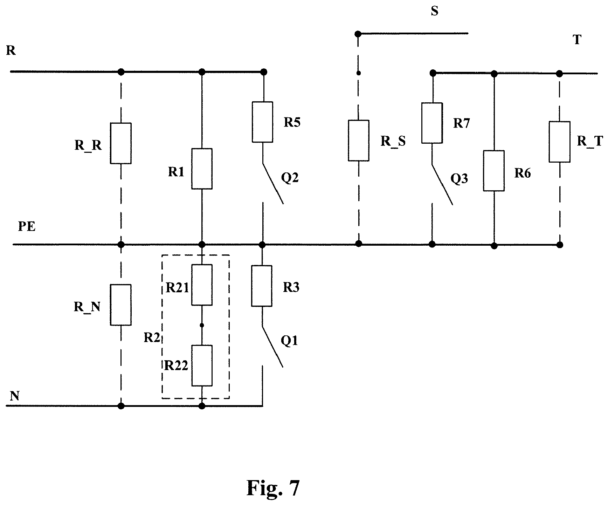

A detection device for detecting insulation impedance of a power gird connected with a photovoltaic inverter against ground is used in the embodiment, with reference to Figure 7, which is a schematic structural diagram of a detection device for detecting insulation impedance of a power gird connected with a photovoltaic inverter against ground according to a fourth embodiment of the present disclosure. Compared with the third embodiment, the detection device in the fourth embodiment further includes a sixth resistor R6, a seventh resistor R7 and a third switch device Q3, where the seventh resistor R7 and the third switch device Q3 are connected in series with each other to form a third series branch. The third series branch is connected in parallel with the sixth resistor R6.

A first end of a second parallel branch including the third series branch and the sixth resistor R6 is connected to the ground wire PE, and a second end of the second parallel branch is connected to the third live line T. The second live line S can be replaced by the third live line T equivalently, that is, the second parallel branch can be connected in parallel with the resistor R_T of the third live line T relative to ground as shown in Figure 7, and alternatively in other embodiment, the second parallel branch can also be connected in parallel with the resistor R_S of the second live line S relative to ground.

The detection device in the embodiment includes three switch devices, and the three switch devices have eight switch states. Similar to the second embodiment, the resistance values of the resistor of each of the live lines and the zero line relative to ground can be calculated by detecting the voltages of each of the live lines and the ground wire PE in any four switch combination states of the eight switch combination states, so as to realize the insulation detection of the power grid against ground. It is determined whether the insulation of the power grid against ground is normal by comparing the resistance value of each of the first live line R, the second live line S, the third live line T and the zero line N relative to ground with a standard value.

Second example

A detection method for detecting insulation impedance of a power gird connected with a photovoltaic inverter against ground is provided in the example. In the detection method, the detection device described in the first example is used to detect insulation impedance of the power grid against ground. The detection method includes step S11 to S12.

In step S11, voltage values of the ground wire and a predetermined live line are acquired in different switch states of a switch device in the detection device, by changing the switch state of the switch device.

Voltages of the ground wire and the first live line in different switch states of the switch device are acquired in a case that the detection device in the first embodiment is used.

In the example described in Figure 1 or in the example described in Figure 2, the detection device only includes one switch device, and the switch device has two switch states, that is, the first switch device is turned off or turned on.

In a case that the first switch device is turned off, a voltage U11 of the ground wire PE and a voltage U21 of the first live line are acquired. The voltage U11 and the voltage U21 can be measured by a voltage measurement device directly. In a case that the first switch device is turned on, a voltage U12 of the ground wire PE and a voltage U22 of the first live line are acquired.

In a case that the second resistor includes two voltage division resistors, in order to acquire the voltage of the ground wire PE, a voltage at a common node of the two voltage division resistors can be acquired first, and the voltage of the ground wire PE can be calculated by carrying out voltage-diving calculation.

In step S12, a resistance value of the resistor of the power grid relative to ground is calculated based on the voltage values.

Taking the example shown in Figure 1 as an example, after voltages of the first live line and the ground wire in different switch states of the switch device are acquired, with reference to the equivalent circuit diagram 3, the resistance value of the resistor of the zero line and the three live lines connected in parallel in the power grid relative to ground is calculated based on the voltages of the ground wire and the first live line, using a node current method.

In a case that the first switch device is turned off, the following node equation is met.

$$\frac{U21 - U11}{R1} + \frac{Ueq - U11}{\mathrm{Re}\,q} = \frac{U11}{R2}$$

In a case that the first switch device is turned on, the following node equation is met.

$$\frac{U22 - U21}{R1} + \frac{Ueq - U22}{\mathrm{Re}\,q} = \frac{U22}{R2} + \frac{U22}{R3}$$

In the two equations described above, the values of R1, R2 and R3 are known, and the resistance Req of the three live lines and the zero line connected in parallel in the power grid relative to ground can be obtained by solving the equations set.

The calculation is also applicable to the example shown in Figure 2, which is not described detailed here.

It is determined whether the insulation of the power grid against ground is normal by comparing the parallel-connected-to-ground resistance Req with a standard value.

Fifth embodiment

Another detection method for detecting insulation of a power gird connected with a photovoltaic inverter against ground is provided in the embodiment. In the detection method, the detection device including two switch devices (a first switch device and a second switch device) in the embodiments described above is used to detect insulation of the power grid against ground.

According to the detection method in the embodiment, voltage values of the ground wire and a predetermined live line are acquired in different switch states of the switch devices by changing the switch state of the switch devices. Since the detection device including two switch devices are used, there are four different switch combination states. The voltages of each live line and the ground wire in the power grid in each switch combination states may be acquired by changing switch combination states of the first switch device and the second switch device.

Then, the resistance values of the resistors of the power gird relative to ground are calculated based on the voltages. The resistors of the power gird relative to ground includes: a resistors R_R of the first live line relative to ground, a resistors R_S of the second live line relative to ground, a resistors R_T of the third live line relative to ground and a resistors R_N of the zero line relative to ground. There are four node equations corresponding to the four switch combination states. the resistance value of the resistor R_R of the first live line relative to ground, the resistance value of the resistor R_S of the second live line relative to ground, the resistance value of the resistor R_T of the third live line relative to ground and the resistance value of the resistor R_N of the zero line relative to ground can be calculated by solving the four node equations.

The detection method in the embodiment is illustrated by taking the embodiment shown in Figure 6 as an example.

In a case that both the first switch device Q1 and the second switch device Q2 are turned off, a voltage U31 of the ground wire PE, a voltage U41 of the first live line and a voltage U51 of the second live line and a voltage U61 of the third live line are acquired.

In a case that the first switch device Q1 is turned on and the second switch device Q2 is turned off, a voltage U32 of the ground wire PE, a voltage U42 of the first live line and a voltage U52 of the second live line and a voltage U62 of the third live line are acquired.

In a case that the first switch device Q1 is turned off and the second switch device Q2 is turned on, a voltage U33 of the ground wire PE, a voltage U43 of the first live line, a voltage U53 of the second live line and a voltage U63 of the third live line are acquired.

In a case that both the first switch device Q1 and the second switch device Q2 are turned on, a voltage U34 of the ground wire PE, a voltage U44 of the first live line, a voltage U54 of the second live line and a voltage U64 of the third live line are acquired.

Based on the voltages in each switch combination state, the following node equations are met.

8

$$\frac{U41-U31}{R1\,/\!/\,R\_R}+\frac{U51-U41}{R\_S}+\frac{U61-U41}{R\_T}=\frac{U41}{R2\,/\!/\,R\_N}$$

$$\frac{U42-U32}{R1\,/\!/\,R\_R}+\frac{U52-U42}{R\_S}+\frac{U62-U42}{R\_T}=\frac{U42}{R2\,/\!/\,R\_N\,/\!/\,R4}$$

$$\frac{U43-U33}{R1\,/\!/\,R\_R\,/\!/\,R5}+\frac{U53-U43}{R\_S}+\frac{U63-U43}{R\_T}=\frac{U43}{R2\,/\!/\,R\_N}$$

$$\frac{U44-U34}{R1\,/\!/\,R\_R\,/\!/\,R5}+\frac{U54-U44}{R\_S}+\frac{U64-U44}{R\_T}=\frac{U44}{R2\,/\!/\,R\_N\,/\!/\,R3}$$

In the four equations described above, the values of R1, R2, R3 and R5 are known, the resistance value of the resistor R_R of the first live line relative to ground, the resistance value of the resistor R_S of the second live line relative to ground, the resistance value of the resistor R_T of the third live line relative to ground and the resistance value of the resistor R_N of the zero line relative to ground can be obtained by solving the equations set.

According to the embodiment of the present disclosure, if other detection device having two switch devices described above is used, the data process is the same as the way described above. The voltages of each live line and the zero line in four switch combination states are acquired. And then, the four equations are solved based on a node current method. And hence the detection method using other detection device having two switch devices is not described detailed here.

It can be seen that, according to the detection method in the embodiment, the resistances of each live line and zero line in the power grid relative to ground are obtained. After the resistances are obtained, it is determined the insulation of each of the zero line and the live lines against ground by comparing the resistance of each line to a standard value.

Sixth embodiment

Another detection method for detecting insulation of a power grid connected to the photovoltaic inverter against ground is provided in the embodiment. Different from the fifth embodiment, in the sixth embodiment, the detection device including three switch devices described above is used to detect insulation of the power grid against ground.

According to the detection method described in the embodiment, voltage values of the ground wire and a predetermined live line are acquired in different switch states of the switch devices by changing the switch state of the switch devices. Since the detection device includes three switch devices, there are eight switch combination states. Only four node equations are required to obtain the resistance values of the resistors of each live line and the zero line relative to ground. Therefore, any four of the eight switch states may be chosen to obtain the voltage values.

Then, the resistance values of the resistors of the power gird relative to ground are calculated based on the voltages. The resistors of the power gird relative to ground includes: a resistors R_R of the first live line relative to ground, a resistors R_S of the second live line relative to ground, a resistors R_T of the third live line relative to ground and a resistors R_N of the zero line relative to ground. In this case, four node equations are built by the voltages in four switch combination states, and the resistance value of the resistor R_R of the first live line relative to ground, the resistance value of the resistor R_S of the second live line relative to ground, the resistance value of the resistor R_T of the third live line relative to ground and the resistance value of the resistor R_N of the zero line relative to ground can be obtained by solving the four node equations.

Similarly, each resistance is calculated based on the voltages in the four switch combination states by using a node current method, and the calculation process will not described detailed here.

According to the detection method described in the embodiment, similarly, the resistances of each live line and the zero line in the power grid relative to ground may be acquired. It is determined the insulation property of any of the zero line and live lines against ground by comparing the acquired resistances to a standard value.

It can be known from the description above, according to the embodiments of the present disclosure, the resistance detection of the power grid relative to ground can be realized, which greatly raises grid-connected security of the grid-connected photovoltaic power generation system. The detection device can be consists only of resistor element(s) and switch device(s). According to the detection method, a voltage value of a node is gathered by controlling the switch states of a switch corresponding to the node, and then the resistance of the power grid relative to ground can be acquired by the node current method, the detection method is simple and practicable, and the cost of the detection device is low.

The above description of the embodiments herein enables those skilled in the art to implement or use the disclosure. Various modifications to these embodiments will be apparent to those skilled in the art. The invention is defined by the claims.

**Claims**

1.  A detection method for detecting insulation of a power grid connected with a photovoltaic inverter against ground, wherein the power grid comprises a first live line (R), a second live line (S), a third live line (T) and a zero line (N), and wherein a detection device is used to detect the insulation of the power grid against ground, the detection device comprising:

    a first resistor (R1), wherein a first end of the first resistor (R1) is connected to a ground wire (PE) of the photovoltaic inverter, and a second end of the first resistor (R1) is connected to the first live line (R);
    a second resistor (R2), wherein a first end of the second resistor (R2) is connected to the ground wire (PE), and a second end of the second resistor (R2) is connected to the zero line (N);
    a first series branch including a third resistor (R3) and a first switch device (Q1) connected in series, wherein a first end of the first series branch is connected to the ground wire (PE), and a second end of the first series branch is connected to the zero line (N) or the first live line (R);
    a fourth resistor (R4); and
    a second series branch including a fifth resistor (R5) and a second switch device (Q2) connected in series, and wherein the second series branch is connected in parallel with the fourth resistor (R4) to from a first parallel branch, wherein a first end of the first parallel branch is connected to the ground wire (PE), and a second end of the first parallel branch is connected to the second live line (S),
    wherein the detection method comprises:

    acquiring voltage values of the ground wire (PE) and the live lines (R, S, T) in different switch states of the switch devices (Q1, Q2) in the detection device by changing the switch state of the switch devices (Q1, Q2), wherein the zero line (N) is a reference zero potential; and
    calculating a value of a resistance of the power grid relative to ground based on the voltage values, wherein acquiring voltage values comprises: acquiring voltages of each live line (R, S, T) and the ground wire (PE) in the power grid in each of at least 4 switch combination states by changing the switch combination state of the first switch device (Q1) and the second switch device (Q2).

2.  The detection method according to claim 1, wherein the detection device further comprises:

    a sixth resistor (R6); and
    a third series branch including a seventh resistor (R7) and a third switch device (Q3) connected in series, wherein the third series branch is connected in parallel with the sixth resistor (R6) to from a second parallel branch, and wherein a first end of the second parallel branch is connected to the ground wire (PE), and a second end of the second parallel branch is connected to the third live line (T),
    wherein acquiring voltage values comprises: acquiring voltages of each live line (R, S, T) and the ground wire (PE) in the power grid in each of at least four switch combination states by changing the switch combination state of the first switch device (Q1), the second switch device (Q2) and the third switch device (Q3).

3.  The detection method according to claim 1, wherein the resistance relative to ground comprises a resistance of the first live line (R) relative to ground, a resistance of the second live line (S) relative to ground, a resistance of the third live line (T) relative to ground and a resistance of the zero line (N) relative to ground; and
    wherein calculating a value of a resistance of the power grid relative to ground comprises:
    calculating the values of the resistance of the first live line (R) relative to ground, the resistance of the second live line (S) relative to ground, the resistance of the third live line (T) relative to ground and the resistance of the zero line (N) relative to ground based on the voltages by using a node current method.

4.  A detection method for detecting insulation of a power grid connected with a photovoltaic inverter against ground, wherein the power grid comprises a first live line (R), a second live line (S), a third live line (T) and a zero line (N), and wherein a detection device is used to detect the insulation of the power grid against ground, the detection device comprising:

a first resistor (R1), wherein a first end of the first resistor (R1) is connected to a ground wire (PE) of the photovoltaic inverter, and a second end of the first resistor (R1) is connected to the first live line (R);
a second resistor (R2), wherein a first end of the second resistor (R2) is connected to the ground wire (PE), and a second end of the second resistor (R2) is connected to the zero line (N);
a first series branch including a third resistor (R3) and a first switch device (Q1) connected in series, wherein a first end of the first series branch is connected to the ground wire (PE), and a second end of the first series branch is connected to the zero line (N) or the first live line (R);a second series branch including a fifth resistor (R5) and a second switch device (Q2) connected in series, wherein a first end of the second series branch is connected to the ground wire (PE), and one of a second end of the second series branch and the second end of the first series branch is connected to the zero line (N), and the other of the second end of the second series branch and the second end of the first series branch is connected to the first live line (R),
wherein the detection method comprises:

acquiring voltage values of the ground wire (PE) and the live lines (R, S, T) in different switch states of the switch devices (Q1, Q2) in the detection device by changing the switch state of the switch devices (Q1, Q2), wherein the zero line (N) is a reference zero potential; and
calculating a value of a resistance of the power grid relative to ground based on the voltage values, wherein acquiring voltage values comprises: acquiring voltages of each live line (R, S, T) and the ground wire (PE) in the power grid in each of at least 4 switch combination states by changing the switch combination state of the first switch device (Q1) and the second switch device (Q2).

5. The detection method according to claim 4,
wherein the detection device further comprises:

a sixth resistor (R6); and
a third series branch including a seventh resistor (R7) and a third switch device (Q3) connected in series, wherein the third series branch is connected in parallel with the sixth resistor (R6) to from a second parallel branch, wherein a first end of the second parallel branch is connected to the ground wire (PE), and a second end of the second parallel branch is connected to the third live line (T),
wherein acquiring voltage values comprises: acquiring voltages of each live line (R, S, T) and the ground wire (PE) in the power grid in each of at least four switch combination states by changing the switch combination state of the first switch device (Q1), the second switch device (Q2) and the third switch device (Q3).

6. The detection method according to claim 4, wherein the resistance relative to ground comprises a resistance of the first live line (R) relative to ground, a resistance of the second live line (S) relative to ground, a resistance of the third live line (T) relative to ground and a resistance of the zero line (N) relative to ground; and
wherein calculating a value of a resistance of the power grid relative to ground comprises:
calculating the values of the resistance of the first live line (R) relative to ground, the resistance of the second live line (S) relative to ground, the resistance of the third live line (T) relative to ground and the resistance of the zero line (N) relative to ground based on the voltages by using a node current method.

**Patentansprüche**

1. Erfassungsverfahren zum Erfassen einer Isolierung eines Energieversorgungsnetzes, das mit einem photovoltaischen Wechselrichter verbunden ist, gegen Masse, wobei das Energieversorgungsnetz eine erste spannungsführende Leitung (R), eine zweite spannungsführende Leitung (S), eine dritte spannungsführende Leitung (T) und eine Nullleitung (N) aufweist, und wobei eine Erfassungsvorrichtung verwendet wird, um die Isolierung des Energieversorgungsnetzes gegen Masse zu erfassen, wobei die Erfassungsvorrichtung aufweist:

einen ersten Widerstand (R1), wobei ein erstes Ende des ersten Widerstands (R1) mit einem Massedraht (PE) des photovoltaischen Wechselrichters verbunden ist, und ein zweites Ende des ersten Widerstands (R1) mit der ersten spannungsführenden Leitung (R) verbunden ist;
einen zweiten Widerstand (R2), wobei ein erstes Ende des zweiten Widerstands (R2) mit dem Massedraht (PE) verbunden ist, und ein zweites Ende des zweiten Widerstands (R2) mit der Nullleitung (N) verbunden ist;

eine erste Reihenverzweigung mit einem dritten Widerstand (R3) und einer ersten Schaltvorrichtung (Q1), die in Reihe geschaltet sind, wobei ein erstes Ende der ersten Reihenverzweigung mit dem Massedraht (PE) verbunden ist, und ein zweites Ende der ersten Reihenverzweigung mit der Nullleitung (N) oder der ersten spannungsführenden Leitung (R) verbunden ist;

einen vierten Widerstand (R4); und

eine zweite Reihenverzweigung mit einem fünften Widerstand (R5) und einer zweiten Schaltvorrichtung (Q2), die in Reihe geschaltet sind, und wobei die zweite Reihenverzweigung parallel zu dem vierten Widerstand (R4) geschaltet ist, um eine erste parallele Verzweigung auszubilden, wobei ein erstes Ende der ersten parallelen Verzweigung mit dem Massedraht (PE) verbunden ist, und ein zweites Ende der ersten parallelen Verzweigung mit der zweiten spannungsführenden Leitung (S) verbunden ist,

wobei das Erfassungsverfahren aufweist:

Akquirieren von Spannungswerten des Massedrahts (PE) und der spannungsführenden Leitungen (R,S,T) in unterschiedlichen Schaltzuständen der Schaltvorrichtungen (Q1,Q2) in der Erfassungsvorrichtung, indem der Schaltzustand der Schaltvorrichtungen (Q1,Q2) geändert wird, wobei die Nullleitung (N) ein Bezugsnullpotenzial ist; und

Berechnen eines Werts von einem Widerstand des Energieversorgungsnetzes relativ zu Masse basierend auf den Spannungswerten,

wobei ein Akquirieren von Spannungswerten aufweist:

Akquirieren von Spannungen von jeder spannungsführenden Leitung (R,S,T) und dem Massedraht (PE) in dem Energieversorgungsnetz in jedem von zumindest vier Schaltkombinationszuständen, indem der Schaltkombinationszustand der ersten Schaltvorrichtung (Q1) und der zweiten Schaltvorrichtung (Q2) geändert wird.

2. Erfassungsverfahren nach Anspruch 1, wobei die Erfassungsvorrichtung ferner aufweist:

einen sechsten Widerstand (R6); und

eine dritte Reihenverzweigung mit einem siebten Widerstand (R7) und einer dritten Schaltvorrichtung (Q3), die in Reihe geschaltet sind, wobei die dritte Reihenverzweigung parallel zu dem sechsten Widerstand (R6) geschaltet ist, um eine zweite parallele Verzweigung auszubilden, und wobei ein erstes Ende der zweiten parallelen Verzweigung mit dem Massedraht (PE) verbunden ist, und ein zweites Ende der zweiten parallelen Verzweigung mit der dritten spannungsführenden Leitung (T) verbunden ist,

wobei ein Akquirieren von Spannungswerten aufweist: Akquirieren von Spannungen von jeder spannungsführenden Leitung (R,S,T) und dem Massedraht (PE) in dem Energieversorgungsnetz in jedem von zumindest vier Schaltkombinationszuständen, indem der Schaltkombinationszustand der ersten Schaltvorrichtung (Q1), der zweiten Schaltvorrichtung (Q2) und der dritten Schaltvorrichtung (Q3) geändert wird.

3. Erfassungsverfahren nach Anspruch 1, wobei der Widerstand relativ zu Masse einen Widerstand der ersten spannungsführenden Leitung (R) relativ zu Masse, einen Widerstand der zweiten spannungsführenden Leitung (S) relativ zu Masse, einen Widerstand der dritten spannungsführenden Leitung (T) relativ zu Masse und einen Widerstand der Nullleitung (N) relativ zu Masse aufweist; und

wobei ein Berechnen eines Werts von einem Widerstand des Energieversorgungsnetzes relativ zu Masse aufweist: Berechnen der Werte des Widerstands der ersten spannungsführenden Leitung (R) relativ zu Masse, des Widerstands der zweiten spannungsführenden Leitung (S) relativ zu Masse, des Widerstands der dritten spannungsführenden Leitung (T) relativ zu Masse und des Widerstands der Nullleitung (N) relativ zu Masse basierend auf den Spannungen, indem ein Knotenstromverfahren verwendet wird.

4. Erfassungsverfahren zum Erfassen einer Isolierung eines Energieversorgungsnetzes, das mit einem photovoltaischen Wechselrichter verbunden ist, gegen Masse, wobei das Energieversorgungsnetz eine erste spannungsführende Leitung (R), eine zweite spannungsführende Leitung (S), eine dritte spannungsführende Leitung (T) und eine Nullleitung (N) aufweist, und wobei eine Erfassungsvorrichtung verwendet wird, um die Isolierung des Energieversorgungsnetzes gegen Masse zu erfassen, wobei die Erfassungsvorrichtung aufweist:

einen ersten Widerstand (R1), wobei ein erstes Ende des ersten Widerstands (R1) mit einem Massedraht (PE) des photovoltaischen Wechselrichters verbunden ist, und ein zweites Ende des ersten Widerstands (R1) mit der ersten spannungsführenden Leitung (R) verbunden ist;

einen zweiten Widerstand (R2), wobei ein erstes Ende des zweiten Widerstands (R2) mit dem Massedraht (PE) verbunden ist, und ein zweites Ende des zweiten Widerstands (R2) mit der Nullleitung (N) verbunden ist; eine erste Reihenverzweigung mit einem dritten Widerstand (R3) und einer ersten Schaltvorrichtung (Q1), die in Reihe geschaltet sind, wobei ein erstes Ende der ersten Reihenverzweigung mit dem Massedraht (PE) verbunden ist, und ein zweites Ende der ersten Reihenverzweigung mit der Nullleitung (N) oder der ersten spannungsführenden Leitung (R) verbunden ist; eine zweite Reihenverzweigung mit einem fünften Widerstand (R5) und einer zweiten Schaltvorrichtung (Q2), die in Reihe geschaltet sind, wobei ein erstes Ende der zweiten Reihenverzweigung mit dem Massedraht (PE) verbunden ist, und eines von einem zweiten Ende der zweiten Reihenverzweigung und dem zweiten Ende der ersten Reihenverzweigung mit der Nullleitung (N) verbunden ist, und das andere von dem zweiten Ende der zweiten Reihenverzweigung und dem zweiten Ende der ersten Reihenverzweigung mit der ersten spannungsführenden Leitung (R) verbunden ist, wobei das Erfassungsverfahren aufweist:

Akquirieren von Spannungswerten der Masseverdrahtung (PE) und der spannungsführenden Leitungen (R,S,T) in unterschiedlichen Schaltzuständen der Schaltvorrichtungen (Q1,Q2) in der Erfassungsvorrichtung, indem der Schaltzustand der Schaltvorrichtungen (Q1,Q2) geändert wird, wobei die Nullleitung (N) ein Bezugsnullpotenzial ist; und
Berechnen eines Werts von einem Widerstand des Energieversorgungsnetzes relativ zu Masse basierend auf den Spannungswerten,
wobei ein Akquirieren von Spannungswerten aufweist: Akquirieren von Spannungen von jeder spannungsführenden Leitung (R,S,T) und dem Massedraht (PE) in dem Energieversorgungsnetz in jedem von zumindest vier Schaltkombinationszuständen, indem der Schaltkombinationszustand der ersten Schaltvorrichtung (Q1) und der zweiten Schaltvorrichtung (Q2) geändert wird.

5. Erfassungsverfahren nach Anspruch 4,
wobei die Erfassungsvorrichtung ferner aufweist:

einen sechsten Widerstand (R6); und
eine dritte Reihenverzweigung mit einem siebten Widerstand (R7) und einer dritten Schaltvorrichtung (Q3), die in Reihe geschaltet sind, wobei die dritte Reihenverzweigung parallel zu dem sechsten Widerstand (R6) geschaltet ist, um eine zweite parallele Verzweigung auszubilden, wobei ein erstes Ende der zweiten parallelen Verzweigung mit dem Massedraht (PE) verbunden ist, und ein zweites Ende der zweiten parallelen Verzweigung mit der dritten spannungsführenden Leitung (T) verbunden ist,
wobei ein Akquirieren von Spannungswerten aufweist: Akquirieren von Spannungen von jeder spannungsführenden Leitung (R,S,T) und dem Massedraht (PE) in dem Energieversorgungsnetz in jedem von zumindest vier Schaltkombinationszuständen, indem der Schaltkombinationszustand der ersten Schaltvorrichtung (Q1), der zweiten Schaltvorrichtung (Q2) und der dritten Schaltvorrichtung (Q3) geändert wird.

6. Erfassungsverfahren nach Anspruch 4, wobei der Widerstand relativ zu Masse einen Widerstand der ersten spannungsführenden Leitung (R) relativ zu Masse, einen Widerstand der zweiten spannungsführenden Leitung (S) relativ zu Masse, einen Widerstand der dritten spannungsführenden Leitung (T) relativ zu Masse und einen Widerstand der Nullleitung (N) relativ zu Masse aufweist; und
wobei ein Berechnen eines Werts von einem Widerstand des Energieversorgungsnetzes relativ zu Masse aufweist: Berechnen der Werte des Widerstands der ersten spannungsführenden Leitung (R) relativ zu Masse, des Widerstands der zweiten spannungsführenden Leitung (S) relativ zu Masse, des Widerstands der dritten spannungsführenden Leitung (T) relativ zu Masse und des Widerstands der Nullleitung (N) relativ zu Masse basierend auf den Spannungen, indem ein Knotenstromverfahren verwendet wird.

**Revendications**

1. Procédé de détection pour détecter l'isolation d'un réseau électrique connecté à un onduleur photovoltaïque vis-à-vis de la terre, dans lequel le réseau électrique comprend une première ligne sous tension (R), une deuxième ligne sous tension (S), une troisième ligne sous tension (T) et une ligne neutre (N), et dans lequel un dispositif de détection est utilisé pour détecter l'isolation du réseau électrique vis-à-vis de la terre, le dispositif de détection comprenant :

un premier résistor (R1), dans lequel une première borne du premier résistor (R1) est connectée à un fil de terre (PE) de l'onduleur photovoltaïque, et une deuxième borne du premier résistor (R1) est connectée à la première ligne sous tension (R) ;

un deuxième résistor (R2), dans lequel une première borne du deuxième résistor (R2) est connectée au fil de terre (PE), et une deuxième borne du deuxième résistor (R2) est connectée à la ligne neutre (N) ;

une première dérivation série comportant un troisième résistor (R3) et un premier dispositif de commutateur (Q1) connectés en série, dans lequel une première borne de la première dérivation série est connectée au fil de terre (PE), et une deuxième borne de la première dérivation série est connectée à la ligne neutre (N) ou à la première ligne sous tension (R) ;

un quatrième résistor (R4) ; et

une deuxième dérivation série comportant un cinquième résistor (R5) et un deuxième dispositif de commutateur (Q2) connectés en série, et dans lequel la deuxième dérivation série est connectée en parallèle au quatrième résistor (R4) pour former une première dérivation parallèle, dans lequel une première borne de la première dérivation parallèle est connectée au fil de terre (PE), et une deuxième borne de la première dérivation parallèle est connectée à la deuxième ligne sous tension (S),

dans lequel le procédé de détection comprend :

l'acquisition de valeurs de tension du fil de terre (PE) et des lignes sous tension (R, S, T) dans des états de commutateur différents des dispositifs de commutateur (Q1, Q2) dans le dispositif de détection en changeant l'état de commutateur des dispositifs de commutateur (Q1, Q2), dans lequel la ligne neutre (N) est un potentiel zéro de référence ; et

le calcul d'une valeur d'une résistance du réseau électrique par rapport à la terre d'après les valeurs de tension,

dans lequel l'acquisition de valeurs de tension comprend : l'acquisition de tensions de chaque ligne sous tension (R, S, T) et du fil de terre (PE) dans le réseau électrique dans chacun d'au moins 4 états de combinaison de commutateur en changeant l'état de combinaison de commutateur du premier dispositif de commutateur (Q1) et du deuxième dispositif de commutateur (Q2).

2. Procédé de détection selon la revendication 1,
dans lequel le dispositif de détection comprend en outre :

un sixième résistor (R6) ; et

une troisième dérivation série comportant un septième résistor (R7) et un troisième dispositif de commutateur (Q3) connectés en série, dans lequel la troisième dérivation série est connectée en parallèle au sixième résistor (R6) pour former une deuxième dérivation parallèle, et dans lequel une première borne de la deuxième dérivation parallèle est connectée au fil de terre (PE), et une deuxième borne de la deuxième dérivation parallèle est connectée à la troisième ligne sous tension (T),

dans lequel l'acquisition de valeurs de tension comprend : l'acquisition de tensions de chaque ligne sous tension (R, S, T) et du fil de terre (PE) dans le réseau électrique dans chacun d'au moins quatre états de combinaison de commutateur en changeant l'état de combinaison de commutateur du premier dispositif de commutateur (Q1), du deuxième dispositif de commutateur (Q2) et du troisième dispositif de commutateur (Q3).

3. Procédé de détection selon la revendication 1, dans lequel la résistance par rapport à la terre comprend une résistance de la première ligne sous tension (R) par rapport à la terre, une résistance de la deuxième ligne sous tension (S) par rapport à la terre, une résistance de la troisième ligne sous tension (T) par rapport à la terre et une résistance de la ligne neutre (N) par rapport à la terre ; et
dans lequel le calcul d'une valeur d'une résistance du réseau électrique par rapport à la terre comprend :
le calcul des valeurs de la résistance de la première ligne sous tension (R) par rapport à la terre, de la résistance de la deuxième ligne sous tension (S) par rapport à la terre, de la résistance de la troisième ligne sous tension (T) par rapport à la terre et de la résistance de la ligne neutre (N) par rapport à la terre d'après les tensions en utilisant une méthode des noeuds.

4. Procédé de détection pour détecter l'isolation d'un réseau électrique connecté à un onduleur photovoltaïque vis-à-vis de la terre, dans lequel le réseau électrique comprend une première ligne sous tension (R), une deuxième ligne sous tension (S), une troisième ligne sous tension (T) et une ligne neutre (N), et dans lequel un dispositif de détection est utilisé pour détecter l'isolation du réseau électrique vis-à-vis de la terre, le dispositif de détection comprenant :

un premier résistor (R1), dans lequel une première borne du premier résistor (R1) est connectée à un fil de terre (PE) de l'onduleur photovoltaïque, et une deuxième borne du premier résistor (R1) est connectée à la première ligne sous tension (R) ;

un deuxième résistor (R2), dans lequel une première borne du deuxième résistor (R2) est connectée au fil de terre (PE), et une deuxième borne du deuxième résistor (R2) est connectée à la ligne neutre (N) ;
une première dérivation série comportant un troisième résistor (R3) et un premier dispositif de commutateur (Q1) connectés en série, dans lequel une première borne de la première dérivation série est connectée au fil de terre (PE), et une deuxième borne de la première dérivation série est connectée à la ligne neutre (N) ou à la première ligne sous tension (R); une deuxième dérivation série comportant un cinquième résistor (R5) et un deuxième dispositif de commutateur (Q2) connectés en série, dans lequel une première borne de la deuxième dérivation série est connectée au fil de terre (PE), et l'une d'une deuxième borne de la deuxième dérivation série et de la deuxième borne de la première dérivation série est connectée à la ligne neutre (N), et l'autre de la deuxième borne de la deuxième dérivation série et de la deuxième borne de la première dérivation série est connectée à la première ligne sous tension (R),
dans lequel le procédé de détection comprend :

l'acquisition de valeurs de tension du fil de terre (PE) et des lignes sous tension (R, S, T) dans des états de commutateur différents des dispositifs de commutateur (Q1, Q2) dans le dispositif de détection en changeant l'état de commutateur des dispositifs de commutateur (Q1, Q2), dans lequel la ligne neutre (N) est un potentiel zéro de référence ; et
le calcul d'une valeur d'une résistance du réseau électrique par rapport à la terre d'après les valeurs de tension,
dans lequel l'acquisition de valeurs de tension comprend : l'acquisition de tensions de chaque ligne sous tension (R, S, T) et du fil de terre (PE) dans le réseau électrique dans chacun d'au moins 4 états de combinaison de commutateur en changeant l'état de combinaison de commutateur du premier dispositif de commutateur (Q1) et du deuxième dispositif de commutateur (Q2).

5. Procédé de détection selon la revendication 4,
dans lequel le dispositif de détection comprend en outre :

un sixième résistor (R6) ; et
une troisième dérivation série comportant un septième résistor (R7) et un troisième dispositif de commutateur (Q3) connectés en série, dans lequel la troisième dérivation série est connectée en parallèle au sixième résistor (R6) pour former une deuxième dérivation parallèle, et dans lequel une première borne de la deuxième dérivation parallèle est connectée au fil de terre (PE), et une deuxième borne de la deuxième dérivation parallèle est connectée à la troisième ligne sous tension (T),
dans lequel l'acquisition de valeurs de tension comprend : l'acquisition de tensions de chaque ligne sous tension (R, S, T) et du fil de terre (PE) dans le réseau électrique dans chacun d'au moins quatre états de combinaison de commutateur en changeant l'état de combinaison de commutateur du premier dispositif de commutateur (Q1), du deuxième dispositif de commutateur (Q2) et du troisième dispositif de commutateur (Q3).

6. Procédé de détection selon la revendication 4, dans lequel la résistance par rapport à la terre comprend une résistance de la première ligne sous tension (R) par rapport à la terre, une résistance de la deuxième ligne sous tension (S) par rapport à la terre, une résistance de la troisième ligne sous tension (T) par rapport à la terre et une résistance de la ligne neutre (N) par rapport à la terre ; et
dans lequel le calcul d'une valeur d'une résistance du réseau électrique par rapport à la terre comprend :
le calcul des valeurs de la résistance de la première ligne sous tension (R) par rapport à la terre, de la résistance de la deuxième ligne sous tension (S) par rapport à la terre, de la résistance de la troisième ligne sous tension (T) par rapport à la terre et de la résistance de la ligne neutre (N) par rapport à la terre d'après les tensions en utilisant une méthode des noeuds.

Fig. 1

Fig. 2

**Fig. 3**

**Fig. 4**

Fig. 5

Fig. 6

**Fig. 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 102751894 A
- CN 202110220 U
- US 2012319660 A1
- GB 2381322 A
- EP 1953890 A2
- EP 2461026 A1